(19) Europäisches Patentamt

European Patent Office

Office européen des brevets

(11) **EP 3 575 821 B1**

(12) **FASCICULE DE BREVET EUROPEEN**

(45) Date de publication et mention
de la délivrance du brevet:
**20.04.2022 Bulletin 2022/16**

(21) Numéro de dépôt: **19176756.5**

(22) Date de dépôt: **27.05.2019**

(51) Classification Internationale des Brevets (IPC):
**G01S 7/40** (2006.01)

(52) Classification Coopérative des Brevets (CPC):
**G01R 29/0892; G01R 29/0871; G01S 7/4052;
G01S 7/4086; G01S 7/4095;** G01R 29/0821;
G01R 31/2822

(54) **PROCÉDÉ ET DISPOSITIF DE GÉNÉRATION D'ENVIRONNEMENTS ÉLECTROMAGNÉTIQUES
COMPLEXES POUR BANCS DE TEST DE SENSEURS ÉLECTROMAGNÉTIQUES**

VERFAHREN UND VORRICHTUNG ZUR ERZEUGUNG VON KOMPLEXEN
ELEKTROMAGNETISCHEN UMGEBUNGEN FÜR PRÜFSTÄNDE VON ELEKTROMAGNETISCHEN
SENSOREN

METHOD AND DEVICE FOR GENERATING COMPLEX ELECTROMAGNETIC ENVIRONMENTS
FOR ELECTROMAGNETIC SENSOR TEST BENCHES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **31.05.2018 FR 1800535**

(43) Date de publication de la demande:
**04.12.2019 Bulletin 2019/49**

(73) Titulaire: **Thales
92400 Courbevoie (FR)**

(72) Inventeurs:
• **BERNARDI, Pierre
78995 ELANCOURT Cedex (FR)**
• **CANET, Julien
78995 ELANCOURT Cedex (FR)**
• **MAGNE, Jean
78995 ELANCOURT Cedex (FR)**

(74) Mandataire: **Marks & Clerk France
Immeuble "Visium"
22, avenue Aristide Briand
94117 Arcueil Cedex (FR)**

(56) Documents cités:
**EP-B1- 2 734 851      US-A- 4 467 327
US-A- 6 114 985**

• **SHIPLEY CHARLES A ET AL: "Transparent array
for simulation of radar targets with full angular
dynamics in any environment", 2018 IEEE
RADAR CONFERENCE (RADARCONF18), IEEE,
23 avril 2018 (2018-04-23), pages 1338-1342,
XP033357082, DOI:
10.1109/RADAR.2018.8378758**
• **WOODS P ET AL: "Precision radar
measurements using a novel compact test
range", 19940101, 1 janvier 1994 (1994-01-01),
pages 2/1-2/5, XP006519535,**

**Description**

L'invention se rapporte au domaine général des senseurs électromagnétiques possédant une ou plusieurs voies de réception. Elle concerne plus particulièrement les équipements de test permettant de simuler des environnements électromagnétiques plus ou moins complexes permettant de tester les performances en matière de détection de tels senseurs.

Les senseurs électromagnétiques tels que les radars, ou tous autres moyens de détection, sont des dispositifs qui permettent de détecter la position, la vitesse et la direction d'un objet, ou cible, dans son environnement. Ils fonctionnent, de manière connue, en émettant un signal électromagnétique dans leur environnement, puis en analysant le signal rétrodiffusé par cet environnement et par tous les objets, ou cibles, qui s'y trouvent.

Les senseurs actuels sont majoritairement des senseurs à impulsions fonctionnant par séquences d'acquisition, chaque séquence étant constituée par l'émission d'un train d'impulsions et l'analyse du signal, rétrodiffusé par l'environnement, consécutif à cette émission. L'écart de temps séparant deux impulsions émises consécutives, ou période de récurrence, définissant de manière connue la distance ambigüe du senseur et par suite la durée des intervalles de réception.

Cet environnement peut être constitué de cibles ponctuelles fixes ou mobiles, véhicules ou aéronefs par exemple.

Cet environnement peut être également constitué d'éléments de terrain, d'étendues marines ou de structures atmosphériques telles que des nuages ou des zones de précipitation. Dans ce cas on assiste à la rétrodiffusion d'échos étendus plus ou moins diffus que l'on qualifie généralement de fouillis (fouillis de sol, fouillis de mer ou fouillis atmosphérique).

Bien souvent, la quantité d'énergie rétrodiffusée par l'environnement géographique et atmosphérique surpasse la quantité d'énergie rétrodiffusée par la ou les cibles qui s'y trouvent, de sorte que, dans la mesure où ils sont mêlés au signal de plus fort niveau rétrodiffusé par l'environnement, les signaux rétrodiffusés par ces objets sont parfois difficile à détecter.

Pour mener à bien cette tâche de détection, le signal rétrodiffusé est enregistré puis traité au moyen de différents algorithmes de façon à permettre la séparation du signal rétrodiffusé par l'environnement du signal utile qui pourrait être masqué par lui. Par signal utile on entend ici un signal rétrodiffusé par un objet d'intérêt que l'on souhaite détecter.

Tester le bon fonctionnement d'un senseur électromagnétique implique donc de tester l'efficacité opérationnelle des algorithmes de détection de cibles mis en œuvre par le senseur. Cette capacité de réaliser ces tests est un point déterminant dans l'élaboration des senseurs actuels et futurs.

Pour ce faire, il est possible de procéder sur le terrain, c'est à dire en installant le matériel à tester sur, ou dans, un véhicule porteur (un avion ou un hélicoptère par exemple), puis en faisant évoluer différentes cibles dans le champ de détection présumé du matériel. La détection, ou non de ces cibles permet d'affirmer, ou non, que le matériel s'est comporté comme prévu lors de sa conception.

Procéder à des tests sur le terrain permet de faire varier les conditions du test et en particulier les conditions d'environnement. On peut par exemple faire évoluer des cibles au-dessus des champs, ou au-dessus de la mer. On peut également effectuer les tests par temps de pluie ou de brouillard, pour vérifier que ces conditions climatiques n'altèrent pas la capacité de détection du matériel testé.

Malheureusement, les tests effectués sur le terrain sont extrêmement onéreux, c'est pourquoi on leur préfère, dans certains cas, ceux réalisés au moyens de bancs de simulation, ou d'installations de test, qui s'avèrent souvent économiquement plus intéressants.

Cependant, les installations de test de senseurs électromagnétiques mises en œuvre actuellement sont généralement conçues pour assurer la simulation des échos ou ORE (Objets RadioElectriques) supposés émaner de sources ponctuelles ou de relativement faible étendue, telles que des échos provenant de cibles, fixes ou mobiles, chaque écho étant généré indépendamment des autres.

De telles installations comportent généralement un panneau rayonnant fixe, un panneau en forme de calotte sphérique par exemple, sur lequel sont placés des éléments rayonnants, des cornets RF par exemple. L'axe de ce panneau rayonnant est orienté en direction du senseur à tester. Elles comportent également divers modules de calcul, dont le rôle est de déterminer la forme et l'amplitude des signaux que doivent émettre les cornets pour un test donné.

Les cornets sont alimentés à travers de moyens de commutation par des générateurs de signaux radioélectriques capables de générer des signaux dont l'amplitude et éventuellement la phase sont contrôlées, de sorte qu'en agissant sur les moyens de commutation on peut alimenter un ou plusieurs éléments rayonnants alternativement ou encore alimenter simultanément un certain nombre d'éléments rayonnants ou de groupes d'éléments rayonnants.

Cependant, le nombre d'éléments rayonnants, de cornets, que l'on peut alimenter simultanément est naturellement fonction du nombre de générateurs de signaux radioélectriques et de moyens de commutation dont l'installation dispose. Or, du fait principalement de leur coût, une installation de test comporte un nombre limité de tels générateurs.

Par suite, même si le panneau rayonnant est de grande dimension et comporte un grand nombre d'éléments rayonnants, le nombre d'éléments rayonnants pouvant être alimentés simultanément est nécessairement limité. Le nombre de cibles ponctuelles qu'une telle installation peut générer simultanément est donc lui aussi limité.

D'un point de vue fonctionnel, du fait de leur structure conçue pour simuler de manière indépendante divers échos ponctuels, de telles installations ne permettent de réaliser des simulations réalistes de scènes électromagnétiques complexes, formées notamment d'échos ponctuels (de cibles) évoluant dans un environnement générant du fouillis, qu'en considérant le signal reçu par le senseur dans un tel environnement comme une multitude d'échos ponctuels provenant de directions distinctes dont la combinaison serait susceptible de constituer au niveau du senseur une approximation du fouillis considéré.

Or simuler un tel nombre d'échos ponctuels, d'ORE, nécessite de disposer des ressources matérielles nécessaires, en l'occurrence un nombre de cornets ainsi qu'un nombre de générateurs de signaux RF suffisants, ce qui n'est généralement pas le cas, du fait du nombre de cornets devant être activés simultanément. Par conséquent il n'est généralement pas envisageable, avec de telles installations de test de créer suffisamment d'ORE pour simuler de manière réaliste un environnement complexe.

Par ailleurs, nonobstant le problème posé par le nombre de sources nécessaire, le principe consistant réaliser la simulation de fouillis à partir de sources radioélectriques localisées sur un panneau rayonnant en stimulant chaque source de manière indépendante en fonction de sa position par rapport au senseur, ne permet pas, par principe, de réaliser une simulation représentative de l'environnement électromagnétique rétrodiffusé par une source de fouillis étendue, du fouillis de sol ou de mer, ou du fouillis atmosphérique par exemple.

En effet le fouillis ayant pour origine des phénomènes naturels complexes, pouvant être localisé n'importe où dans l'espace environnant le senseur et être plus ou moins étendus, simuler un fouillis par ce principe nécessite de générer un environnement électromagnétique s'étendant sur une zone angulaire bien plus grande (s'étendant typiquement sur $2\pi$ stéradians) que la zone angulaire couverte par les éléments rayonnants, les cornets, nécessairement localisés sur la surface du panneau rayonnant équipant l'installation de test considérée, zone limitée à l'étendue angulaire couverte par le panneau rayonnant.

On constate donc que les installations de test existantes qui sont adaptées à la simulation d'objets radioélectriques (ORE) ponctuels ne permettent pas, du fait du nombre de sources pouvant être activées simultanément et de la position de ces sources sur un panneau d'étendue limitée, de simuler un environnement complexe de manière réaliste. Or, les futures générations de senseurs électromagnétiques sont appelées à mettre en œuvre des traitements des signaux reçus permettant de discerner les signaux émanant d'une ou plusieurs cibles du bruit électromagnétique de fond, ou fouillis, émanant de l'environnement. Par suite, les installations de test qui seront utilisées pour tester ces futurs instruments, devront être pourvues de moyens leur permettant de simuler non seulement des cibles, mais également du fouillis.

Un document US 6 114 985 A divulgue un dispositif de génération d'environnements électromagnétiques.

Un but de l'invention est de proposer une solution permettant d'utiliser des installations de test existantes, capables d'activer un nombre limité de sources radioélectriques ponctuelles réparties dans un secteur angulaire limité par rapport au secteur angulaire couvert par le matériel sous test, de façon à pouvoir simuler une scène électromagnétique complexe correspondant à un environnement générateur de fouillis.

Un autre but de l'invention est de proposer une solution permettant de simuler une scène électromagnétique incluant une ou plusieurs cibles en évolution dans un environnement générateur de fouillis.

A cet effet l'invention a pour objet, un dispositif de génération d'environnements électromagnétiques complexes destiné à produire des signaux électromagnétiques de test pour stimuler un senseur lectromagnétique comportant N voies de réception, ledit senseur étant lacé, sur un support, dans une enceinte de test comportant une chambre anéchoïque ainsi qu'un panneau rayonnant constitué d'au moins N sources rayonnantes et configuré pour être raccordé à un équipement de génération de signaux RF d'excitation, et pour rayonner l'onde électromagnétique correspondante à l'intérieur de la chambre anéchoïque vers le matériel sous test. Le dispositif selon l'invention comporte principalement:

- un module de définition de scènes électromagnétiques qui délivre des données qui définissent l'environnement électromagnétique que l'on veut simuler et auquel on veut soumettre le senseur sous test;

- un calculateur de scènes électromagnétiques qui produit des ensembles de cartes Doppler - distance, chaque carte représentant, pour une séquence d'acquisition donnée et pour une voie de réception donnée du senseur, la distribution en fréquence, en fonction de la distance, de la puissance du signal reçu pour l'environnement électromagnétique défini par le module de définition de scènes électromagnétiques;

- un module de suppression de transfert qui modifie chaque carte Doppler - distance produite par le calculateur de scènes électromagnétiques de façon à produire une cartes Doppler - distance modifiée, correspondant au signal que doit rayonner une sources rayonnante donnée du panneau rayonnant pour simuler, au niveau des voies de réception du senseur, l'environnement électromagnétique souhaité pour la séquence d'acquisition correspondante;

- des modules de synthèse et d'amplification de signaux radiofréquence (RF), chaque module réalisant la synthèse du signal RF correspondant à une carte Doppler - distance modifiée donnée, produite par le module de suppression de transfert, le signal RF produit étant délivré à une source rayonnante donnée.

Selon diverses dispositions pouvant être considérées séparément ou en combinaison les unes avec les autres, le dispositif selon l'invention peut comporter les caractéristiques techniques suivantes.

Selon une première caractéristique, le support de l'enceinte de test étant une table trois axes, le dispositif comporte un module d'acquisition des données provenant de ladite table trois axes, données qui sont transmises au module de suppression de transfert.

Selon une autre caractéristique, le dispositif selon l'invention comporte un module d'acquisition de données de fonctionnement du senseur, données qui sont transmises au module de suppression de transfert et au calculateur de scènes électromagnétiques.

Selon une autre caractéristique, le dispositif selon l'invention comporte en outre des moyens de commutation permettant de connecter chaque module de synthèse et d'amplification de signaux à l'une ou l'autre des sources rayonnantes du panneau rayonnant.

Selon une autre caractéristique, le module de suppression de transfert comporte:

- un processeur configuré pour construire la matrice inverse $T^{-1}$ de la matrice de transfert T qui caractérise la propagation des ondes électromagnétiques émises par les sources rayonnantes du panneau rayonnant jusqu'aux modules de réception du senseur pour une fréquence Doppler donnée;

- un multiplieur configuré pour effectuer le produit de la matrice inverse $T^{-1}$ par un vecteur réception dont les N composantes correspondent, pour une séquence d'acquisition donnée du senseur, aux valeurs de l'amplitude de signal mesurée dans une même cellule doppler-distance de chacune des N cartes Doppler - distance produites par le calculateur de scènes électromagnétiques pour la séquence d'acquisition considérée. Le multiplieur délivre un vecteur émission à N composantes, chaque composante représentant la valeur de l'amplitude du signal à émettre par la source rayonnante considéré mesuré pour une même cellule doppler-distance de chacune des cartes doppler-distance modifiées délivrées par le module de suppression de transfert.

Selon une autre caractéristique, le processeur du module de suppression de transfert est configuré pour calculer une matrice inverse $T^{-1}$ distincte pour chacune des fréquences doppler définissant les cellules doppler-distance des cartes doppler-distance produites par le calculateur de scènes électromagnétiques.

Selon une autre caractéristique, le processeur du module de suppression de transfert est configuré pour calculer une matrice inverse $T^{-1}$ commune unique, ladite matrice étant calculée pour la fréquence doppler définissant la cellule doppler-distance centrale des cartes doppler-distance produites par le calculateur de scènes électromagnétiques.

Selon une autre caractéristique, chaque module de synthèse et d'amplification de signaux radiofréquence (RF) du dispositif selon l'invention comporte:

- un processeur configuré pour mettre en œuvre une opération de transformation permettant de transformer la carte doppler-distance modifiée à laquelle il est associé en une carte temps court-temps long constitué de cellules, l'amplitude du signal dans chaque cellule correspondant à l'amplitude du signal à rayonner pour une case distance donnée et une récurrence donnée du signal d'excitation;

- un module synthétiseur configuré pour générer un signal électromagnétique temporel fonction, pour chaque récurrence, des amplitudes de signal dans chacune des cellules temps court-temps long de la carte temps court-temps long définies par un même numéro de récurrence sur l'axe temps long.

L'invention a également pour objet un procédé de génération d'environnements électromagnétiques complexes destiné à produire des signaux électromagnétiques de test pour stimuler un senseur électromagnétique sous test placé, sur un support, dans une enceinte de test comportant une chambre anéchoïque ainsi qu'un panneau rayonnant constitué d'une pluralité de sources rayonnantes et configuré pour être raccordé à un équipement de génération de signaux RF d'excitation, et rayonner l'onde électromagnétique correspondante à l'intérieur de la chambre anéchoïque vers le senseur à tester. Ledit procédé est destiné à mettre en œuvre un dispositif de génération d'environnements électromagnétiques complexes selon l'invention. Il comporte à cet effet:

- une première opération consistant à former, pour un scénario d'environnement électromagnétique donné, des cartes Doppler - distance telles que celles qui pourraient être constituées par le senseur à tester, pour chacune de ses voies de réception, dans un tel environnement, à partir des signaux captés par les modules de réception dudit senseur;

- une deuxième opération consistant à supprimer, au niveau de chaque carte Doppler - distance formée, le transfert à travers la chambre anéchoïque, en prenant en compte la position du senseur à tester relativement aux sources rayonnantes du panneau rayonnant mises en œuvre, de façon à former des cartes Doppler - distance modifiées représentant les spectres des signaux que doivent émettre les sources rayonnantes pour que le senseur perçoive un environnement électromagnétique correspondant sensiblement au scénario élaboré;

- une troisième opération consistant, pour les générateurs de signaux, à convertir en signaux temporels les spectres des signaux correspondant aux cartes Doppler - distance modifiées, puis à rayonner ces signaux vers le senseur, via les sources rayonnantes, à travers la chambre anéchoïque.

Selon une caractéristique technique particulière, le procédé selon l'invention comporte en outre une opération complémentaire consistant à faire l'acquisition des signaux captés par les modules de réception du senseur pendant le déroulement du scénario de test considéré et de former des carte Doppler - distance à partir des signaux enregistrés, lors du test, au niveau des modules de réception du senseur pour chacune des voies de réception.

L'invention permet avantageusement de simuler des scènes électromagnétiques complexes en utilisant les équipements dont on dispose dans les installations de test existantes; en particulier en utilisant la chambre anéchoïque, la table trois axes, et le panneau rayonnant dont une telle installation est généralement pourvue.

Elle présente encore l'avantage de ne nécessiter la mise en œuvre que d'un nombre de cornets rayonnants égal au nombre N de voie de réception du senseur sous test. On limite ainsi avantageusement le nombre de générateurs de signaux RF et de cornets nécessaires à la simulation d'un environnement électromagnétique. L'invention offre donc un moyen simple pour simuler simultanément des échos cibles et des signaux perturbateurs, fouillis ou autres; moyen qui met en jeu une architecture matérielle plus légère que celles exploitée aujourd'hui

L'invention proposée permet en outre, avantageusement, de simuler des scènes électromagnétiques sans limitation angulaire.

Elle présente par ailleurs une configuration beaucoup plus flexible que les installations existantes, dépendant moins de l'utilisation d'une table trois axes en tant que support de l'équipement à tester.

Les caractéristiques et avantages de l'invention seront mieux appréciés grâce à la description qui suit, description qui s'appuie sur les figures annexées qui présentent:

la figure1, la représentation schématique fonctionnelle d'une installation de test selon l'art antérieur;

la figure 2, la représentation schématique fonctionnelle d'un exemple d'installation de test dans lequel le dispositif selon l'invention est intégré;

la figure 3, une représentation schématique d'une carte Doppler - distance mise en œuvre dans le cadre de l'invention;

la figure 4, un schéma de principe illustrant la structure et le fonctionnement du module de suppression de transfert du dispositif selon l'invention;

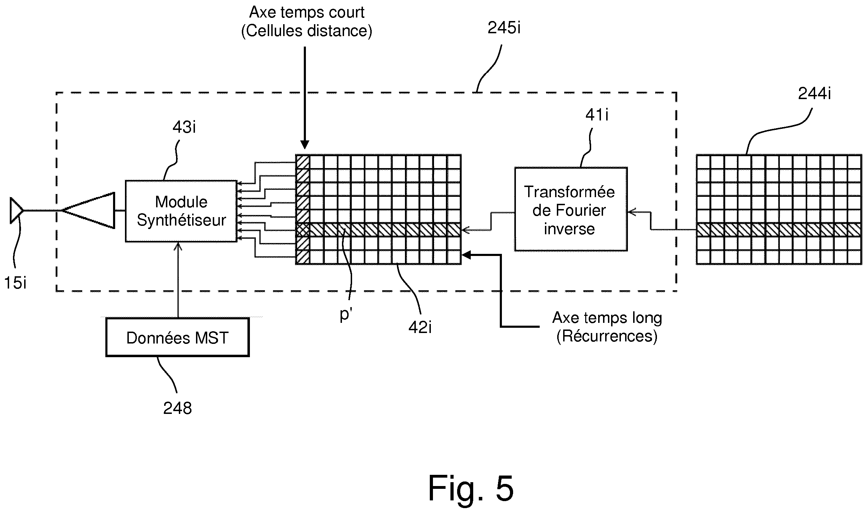

la figure 5, un schéma de principe illustrant la structure et le fonctionnement du module générateur de signal d'excitation du dispositif selon l'invention;

Il est à noter que, sur les figures annexées, un même élément fonctionnel ou structurel porte de préférence un même symbole repère.

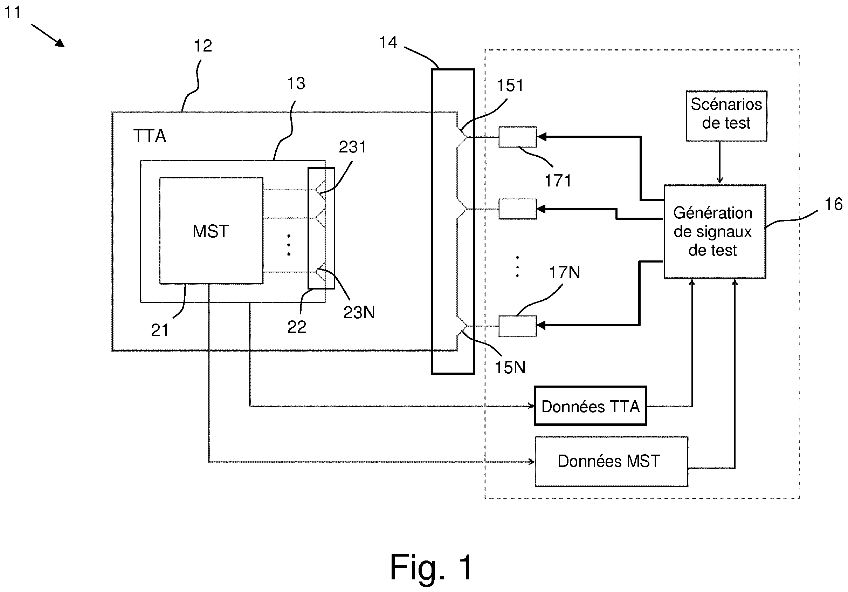

La figure 1 présente une illustration schématique d'une Installation de test 11 du type connu de l'art antérieur.

Une telle installation 11 comporte une chambre anéchoïque 12, dans laquelle est installé un support 13 destiné à recevoir le senseur à tester. Comme illustré par la figure 1, le support 13 est généralement une table trois axes (TTA), ou tout autre dispositif équivalent permettant de faire varier l'orientation et/ou l'attitude d'un objet qui est monté sur ce dernier. Cependant dans une forme de réalisation simple l'installation 11 peut simplement comporter un support fixe.

La chambre anéchoïque 12 a pour fonction d'atténuer autant que possible, sinon de supprimer totalement, les signaux radioélectriques parasites pouvant provenir de l'environnement de l'installation considérée.

La table trois axes 13 est configurée de façon à pouvoir accueillir un senseur 21 sous test (MST), ledit senseur étant alors fixé sur la table trois axes (TTA). Le senseur 21 sous test considéré ici comporte une antenne modulaire 22 constituée de plusieurs modules de réception 231 à 23N.

Une telle installation 11 comporte également un panneau rayonnant 14 qui fait face à la table trois axes (ou au support) 13 et sur lequel sont positionnés des cornets rayonnants radiofréquence 151 à 15N. Dans la suite de la description on utilisera le terme de "cornets rayonnants" de façon générique, étant entendu que dans le cadre de l'invention ces cornets rayonnants peuvent être remplacés par tous autres éléments capables de rayonner une onde radioélectrique.

Les cornets 151 à 15N sont configurés et agencés sur le panneau rayonnant 14 de façon à émettre des signaux radiofréquence dont les plans d'ondes se recombinent au voisinage des modules de réception 231 à 23N du senseur sous test 21 lorsque celui-ci est monté sur la table trois axes (TTA) (ou sur le support) 13. Les signaux recombinés sont supposés proches de ceux qu'aurait rétrodiffusés un environnement électromagnétique complexe.

Selon l'installation considérée, le panneau rayonnant peut comporter un nombre M de cornets plus grand que le nombre N de voies de réception du senseur sous test (MST) 21. Cependant, dans le cadre de l'invention, on utilise préférentiellement un nombre de cornets 15 égal au nombre de voies de réception du senseur; sachant que le nombre de cornets doit être au moins égal au nombre de voies de réception. De la sorte, comme il apparaîtra dans la suite du texte, la relation de transfert peut s'écrire sous la forme d'un système linéaire dont la matrice est carrée.

Néanmoins, lorsque le panneau rayonnant de l'installation possède plus de cornets 15 que le senseur 21 n'a de voies de réception, les cornets exploités peuvent être choisis en fonction de leurs positions sur le panneau rayonnant 14, de manière à minimiser l'impact d'un défaut d'émission sur le signal à reproduire.

L'Installation de test 11 comporte en outre un module de génération de signaux de test 16 qui assure la génération de scénarios de test et dont le rôle est de générer, en fonction du scénario de test considéré, les signaux de commande et de synchronisation destinés à piloter les générateurs de signaux radioélectriques 17a à 17N chargée de générer le signaux d'excitation transmis aux cornets 151 à 15N du panneau rayonnant 14 utilisés pour réaliser le test.

Ces commandes et synchronisations sont fonction du mode de fonctionnement adopté pour le test considéré par le senseur sous test (MST) 21. Ces informations concernant le mode de fonctionnement du senseur peuvent être transmises à l'unité de production de signaux de test 16 par un module d'acquisition 18 de données senseur connecté lui-même au senseur 21.

Ces commandes et synchronisations sont également fonction des données d'altitude, de vitesse et d'orientation du porteur, l'orientation étant simulée au moyen de la table trois axes (TTA) dans le cas où le support 13 est constitué par une telle table, les données d'orientation étant transmises à l'unité de production de signaux de test 16 par un module 247 d'acquisition des données 19 relatives à la table trois axes, module relié à cette dernière par tout moyen de liaison approprié, liaison filaire ou autre.

Les cornets sont alimentés à travers des moyens de commutation (non représentés sur la figure) par les générateurs de signaux radioélectriques 171 à 17N.

Comme on peut le constater sur le schéma de la figure 1, l'unité de production de signaux de test 16 réalise la commande séparée de chacun des générateurs 171 à 17N de signaux radioélectriques, chaque générateur produisant un signal RF destiné à alimenter simultanément un ou plusieurs cornets, ou groupes de cornets, de façon à constituer un ou plusieurs ORE ponctuels. Comme cela a été dit précédemment, une telle installation est donc par principe conçue pour simuler des échos ponctuels ou de faible étendue plutôt que des environnements comportant du fouillis.

La suite de la description présente de manière détaillée la structure fonctionnelle du dispositif 24 de génération d'environnements électromagnétiques complexes selon l'invention, ainsi que le principe de fonctionnement des différents modules qui composent ce dispositif.

Ce dispositif peut avantageusement être intégré à une installation de test existante, en se substituant à une unité de production de signaux de test 16 classique ou en fonctionnant en parallèle avec cette dernière. Il peut également faire partie d'une installation de test spécialement conçue pour optimiser le test de senseur en tirant totalement parti des avantages fonctionnels que procure le dispositif, notamment en termes de nombre de cornets, pour la réalisation des environnements de test envisagés.

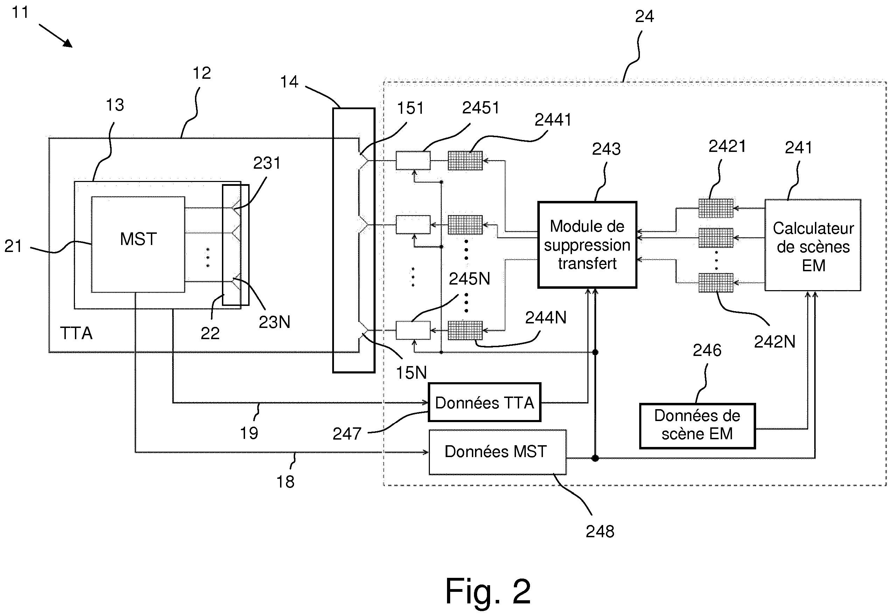

Dans la forme de réalisation schématisée par la figure 2, présentée à titre d'exemple non limitatif, le dispositif de génération d'environnements électromagnétiques complexes 24 selon l'invention comporte principalement:

- un calculateur de scènes électromagnétiques 241 ;

- un module de suppression de transfert 243;

- des modules de synthèse et d'amplification de signaux RF 2451 à 245N;

- un module de définition de scènes électromagnétiques 246;

- un module 247 d'acquisition de données provenant de la table trois axes 13;

- un module 248 d'acquisition de données provenant du senseur 21.

Il est à noter ici que le module 248 d'acquisition de données provenant du senseur 21 peut être absent de certaines formes de réalisation du dispositif 24 selon l'invention. Il s'agit en particulier des formes de réalisation assurant un fonctionnement dit en boucle ouverte pour lesquelles l'environnement simulé est un environnement statique.

Le calculateur de scènes électromagnétiques 241 a pour fonction principale de réaliser la simulation d'une scène électromagnétique donnée, cette simulation étant basée sur une modélisation physique d'un environnement donné du senseur 21. La simulation est réalisée en prenant en compte des paramètres d'entrée caractérisant la scène électromagnétique que l'on souhaite simuler ainsi que, de manière préférentielle, les données de fonctionnement du senseur sous test 21 lui-même.

Cette simulation se matérialise par l'estimation et la production, par toute méthode connue par ailleurs et non décrite ici, d'ensembles de cartes Doppler - distance, 2421 à 242N, qui représentent, pour chaque module de réception 231 à 23N de l'antenne 22 du senseur, la distribution en fréquence de la puissance du signal reçu en fonction de la distance, pour un environnement électromagnétique correspondant à la scène considérée et pour la forme d'onde exploitée par le senseur.

Ainsi, par exemple en ce qui concerne une simulation de cible mobile donnée, la carte Doppler distance correspondante pourra être déterminée en considérant le modèle d'évolution de la cible considérée (évolution des vecteurs vitesse et accélération et de la surface équivalente par exemple).

Par ailleurs, en ce qui concerne une simulation d'environnement, la carte Doppler distance correspondante pourra être déterminée, par exemple, en discrétisant la géométrie de l'environnement en éléments, puis, pour chaque élément, en calculant la puissance rétrodiffusée par l'élément considéré, en calculant la couverture vitesse (Doppler) - distance de cet élément, puis enfin en introduisant la puissance rétrodiffusée par cet élément dans la zone vitesse - distance correspondante de la carte.

Dans le cadre d'un fonctionnement en boucle ouverte de l'installation de test dans laquelle se trouve le dispositif, les cartes Doppler distances successives sont mémorisées et exploitées successivement à mesure du déroulement de la scène électromagnétique simulée. Autrement dit, chaque groupe de cartes 2421 à 242N concernant une séquence de fonctionnement du senseur est mémorisée dans une table, contenue dans un circuit mémoire par exemple, de façon à rester disponible pendant toute la période d'analyse de la scène par le senseur 21 et aussi longtemps que la scène électromagnétique simulée n'engendre pas de modification de cette carte.

Par fonctionnement en boucle ouverte on entend ici un fonctionnement pour lequel les paramètres cinématiques du senseur et leur évolution sont déterminés a priori de sorte que la scène électromagnétique à simulée peut être une scène mémorisée pour être jouée en temps voulu

En revanche dans un fonctionnement en boucle fermée, les cartes Doppler distances correspondant à la simulation, sont générées de manière dynamique pour la période d'analyse en cours réalisée par le senseur et exploitée directement.

Par fonctionnement en boucle fermée on entend ici un fonctionnement pour lequel les paramètres cinématiques du senseur sont pris en compte en temps réel, la scène électromagnétique simulée devant prendre en compte ces paramètres au fur et à mesure de leur évolution. La scène électromagnétique simulée est alors dépendante de l'état de ces paramètres.

Comme il a été dit précédemment, le fouillis a pour origine des phénomènes naturels complexes dont il est généralement impossible de réaliser une simulation complètement exacte dans un temps raisonnable, autrement dit un temps inférieur au temps séparant deux séquences d'acquisition.

D'une manière générale, les paramètres d'entrée permettant de générer de telles cartes Doppler - distance peuvent être classés en deux catégories:

- les paramètres de fonctionnement de l'équipement sous test (cinématique du porteur, formes d'ondes traitées, paramètres émetteur, paramètres récepteur, ...),
- les paramètres d'environnement qui définissent les conditions de fonctionnement que l'on souhaite simuler.

Ainsi, dans le cas de la simulation d'un fouillis de pluie par exemple, ces paramètres concerneront les propriétés de la pluie, notamment son étendue, son débit et son coefficient d'atténuation.

De même, dans le cas de la simulation d'une cible, cela pourra être sa cinématique et sa surface équivalente.

De même encore, dans le cas de la simulation d'un fouillis de sol, ces paramètres pourront notamment concerner, en fonction de l'incidence de l'onde radar, la topographie du terrain, le coefficient de rétrodiffusion des différentes zones topographiques (forêts, mer, champs, surfaces enneigées...).

D'un point de vue matériel, le calculateur de scènes électromagnétiques 241 peut consister en un composant programmable de type FPGA ou un CPU, éventuellement associé à des moyens de mémorisation.

Les données ou paramètres caractérisant la scène électromagnétique que l'on souhaite simuler sont transmis au calculateur de scènes électromagnétiques 241 par le module de définition 246. Les données de scène électromagnétique définissent l'environnement électromagnétique du senseur 21 que l'on veut simuler. De manière générale, elles dépendent du type de scène que l'on souhaite simuler.

Ainsi, par exemple, si le test effectué consiste à étudier le comportement du senseur 21 en présence de pluie, les données de scène électromagnétique fournies par le module de définition 246 porteront par exemple sur la position, la vitesse, la forme, le débit de la pluie.

En revanche, si le test consiste à étudier l'impact du fouillis de sol sur les performances de détection du senseur, alors les données de scène électromagnétique pourront contenir les coefficients de rétrodiffusion du sol et les zones géographiques auxquelles s'appliquent ces coefficients ainsi que la topographie du terrain simulé.

D'une manière générale, les données de scène électromagnétique et, très généralement, les données opérationnelles propres au senseur 21 constituent ainsi les paramètres d'entrée du calculateur de scènes électromagnétiques 241. Ces paramètres sont variables en fonction du type d'environnement simulé et du degré d'interdépendance de fonctionnement du senseur et de l'installation.

Le module 246 qui permet au calculateur de scène 241 d'élaborer les cartes Doppler - distance peut, par exemple, consister en un bloc mémoire contenant les données de scène, adressé directement par le calculateur de scène.

Les données de fonctionnement du senseur 21 sont transmises au calculateur de scènes électromagnétiques 241 par le module 248 d'acquisition des données de fonctionnement du senseur. Les données acquises peuvent consister notamment en la direction du vecteur d'antenne ainsi qu'en les caractéristiques de la forme d'onde exploitée par le senseur.

Ce module réalise l'acquisition de ces données de manière périodique pour chaque période d'analyse du senseur 21. Le flux de données de fonctionnement du senseur 21 peut en effet changer à chaque nouvelle séquence d'acquisition du signal radioélectrique reçu. Le module 248 d'acquisition de données senseur réalise donc leur acquisition pour chaque nouvelle séquence d'acquisition du signal radioélectrique par le senseur et transmet ces données au calculateur 241 avec cette même périodicité.

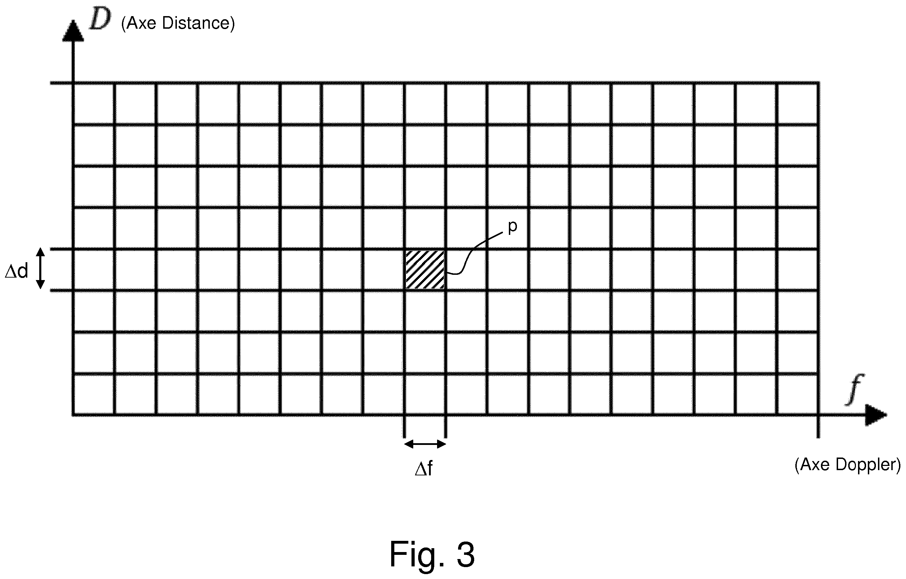

La Figure 3 représente de manière graphique une carte Doppler - distance 242. Cette carte est composée de cases ou cellules définies chacune par une bande de fréquence doppler et par un intervalle de distance, l'étendue de la bande de fréquence doppler et de l'intervalle de distance définissant la résolution des cellules formant la carte

Chaque cellule ainsi définie renferme un échantillon de signal, un pixel p, dont la valeur représente l'amplitude de la composante spectrale correspondante du signal reçu pour la distance considérée.

Dans le cadre de l'invention, et selon le mode de fonctionnement considéré, les cartes Doppler-distance 2421 à 242N produites par le calculateur de scènes électromagnétiques 241 peuvent présenter une excursion en fréquence et en distance suffisante pour couvrir la totalité du spectre doppler et de l'espace nécessaires à la création de l'environnement électromagnétique à simuler. Dans ce cas cependant, les cartes Doppler-distance 2421 à 242N à produire présentent un nombre important de cellules de sorte que leur production requiert plus de temps de calcul

Alternativement, sachant que le senseur à tester présente une certaine ambiguïté en distance et doppler et que pour des distances et des fréquences doppler situées au-delà des zones non ambiguës on assiste à un repliement en doppler et en distance du signal reçu, les cartes Doppler-distance 2421 à 242N produites par le calculateur de scènes électromagnétiques 241 peuvent présenter des excursions en fréquence et en distance limitées simplement aux zones non ambiguës.

Dans ce second cas, cependant, dans la mesure où les étendues des zones non ambiguës en distance et en doppler sont susceptibles de varier en fonction du mode de fonctionnement adopté par le senseur pour une période d'analyse donnée, il est nécessaire de prendre en compte, pour la génération de l'environnement électromagnétique simulé, les paramètres de fonctionnement du senseur, tels que sa fréquence et sa distance d'ambiguïté, et de dimensionner les cartes doppler - distance de manière à couvrir les plages de fréquence doppler et de distance correspondantes, de sorte que la génération de ces cartes est rendue plus complexe.

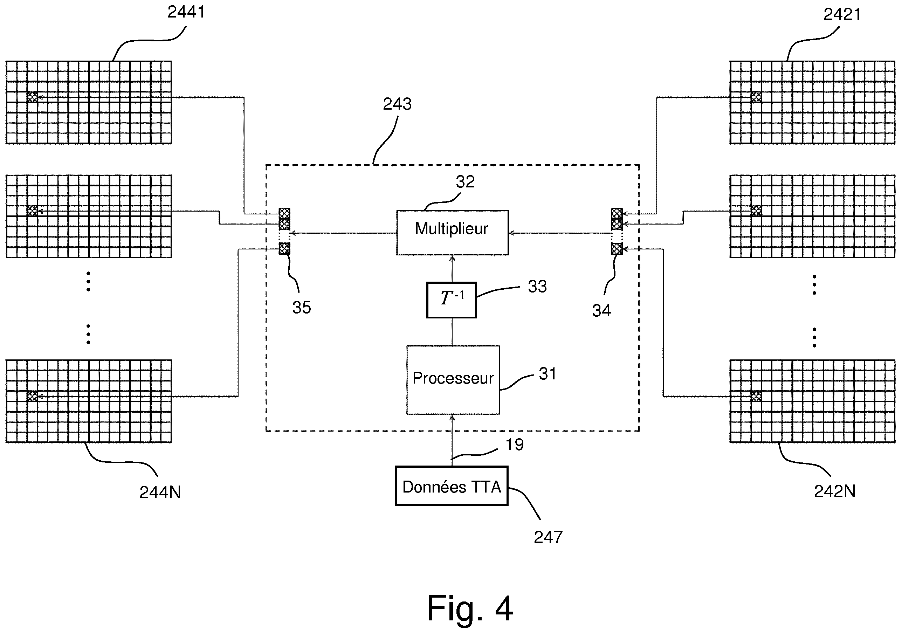

Le module de suppression de transfert 243 a pour fonction, comme l'illustre la figure 4, de convertir les cartes Doppler - distance 2421 à 242N estimées, produites par le calculateur de scènes électromagnétiques 241 au niveau des modules de réception 231 à 23N du senseur 21, en cartes Doppler - distance 2441 à 244N modifiées, représentatives des signaux que doivent émettre les cornets 151 à 15N pour que le senseur 21 perçoive un signal équivalent à celui qu'aurait rétrodiffusé la scène simulée par le calculateur de scènes électromagnétiques 241; autrement dit, pour que les signaux effectivement perçus par les modules de réception 231 à 23N de l'antenne 22 du senseur 21 soient sensiblement égaux aux signaux perçus qu'aurait rétrodiffusé la scène électromagnétique simulée par le calculateur de scènes électromagnétiques 241.

Pour estimer les cartes Doppler - distance 2441 à 244N, le module de suppression de transfert 243 calcule et applique aux cartes Doppler - distance 2421 à 242N le transfert inverse du transfert introduit par l'espace entre les cornets 151 à 15N et les modules de réception 231 à 23N de l'antenne 22 du senseur 21. Pour ce faire, le module de suppression de transfert 243 exploite les données 19 provenant de la table trois axes 13, ainsi que les données 18 provenant du senseur 212.

Pour effectuer cette opération, le module de suppression de transfert 243, met en œuvre, comme l'illustre la figure 3, un processeur 31 et un multiplieur 32, ces deux éléments pouvant être constitués par deux composants électroniques séparés ou alternativement être intégrés dans un même composant électronique, un microprocesseur ou un FPGA par exemple.

Alternativement, le processeur 31 et le multiplieur 32 peuvent consister en deux fonctions intégrées au circuit électronique constituant le calculateur de scènes électromagnétiques 241.

L'opération de suppression de transfert consiste dans un premier temps à construire la matrice inverse $T^{-1}$ 33 de la matrice de transfert T caractérisant le transit des signaux des cornets 151 à 15N du panneau rayonnant aux modules de réception 231 à 23N de l'antenne 22 du senseur 21 pour une fréquence Doppler donnée, une matrice différente pouvant être construite pour chacune des fréquences Doppler de la carte considérée.

Cependant du fait de la faible variation constatée dans les coefficients des différentes matrices, le dispositif selon l'invention peut, dans un mode de réalisation simplifié, ne calculer et exploiter qu'une seule matrice ou un nombre limité de matrices pour l'ensemble de la carte considérée, la matrice correspondant à la fréquence doppler centrale par exemple. Cette opération est réalisée par le processeur 31.

Les coefficients de la matrice T dépendent de la fréquence de travail du senseur 21 et de la position des modules de réception 231 à 23N par rapport aux cornets 151 à 15N. On montre en effet que, d'un point de vue théorique, les équations de Maxwell qui régissent la propagation des ondes électromagnétiques dans l'espace étant linéaires, on peut écrire:

$$R = T \cdot E \qquad\qquad [001]$$

Dans l'équation [001], E est le vecteur résultant de la concaténation de l'amplitude des signaux émis par les cornets 151 à 15N et R est le vecteur résultant de la concaténation de l'amplitude des signaux enregistrés par les modules de réception 231 à 23N de l'antenne 22 du senseur21.

Par suite on peut écrire de manière réciproque:

$$E = T^{-1} \cdot R \qquad\qquad [002]$$

pour autant que cela ait un sens.

Or Il est à noter ici que les valeurs des coefficients de la matrice T, dépendent des positions relatives des cornets 151 à 15N et des modules de réception 231 à 23N ainsi que des caractéristiques d'émission des cornets et des caractéristiques de réception des modules d'antenne.

Par suite pour que l'équation [002] présente une solution $T^{-1}$ il suffit donc d'agencer les cornets d'émission RF 151 à 15N de telle façon que la condition suivante soit vérifiée:

$$Det(T) \neq 0 \qquad\qquad [003]$$

Par conséquent, la condition [003] étant satisfaite, et connaissant la position des cornets d'émission RF 151 à 15N, La matrice $T^{-1}$ peut être estimée de différentes façons.

La matrice $T^{-1}$ peut ainsi être déterminée analytiquement, à partir de relations linéaires exprimant l'amplitude des signaux reçus au niveau de chaque module d'antenne comme la somme des signaux émis par les différents cornets, chaque signal étant affecté d'un déphasage fonction de la distance entre le module considéré et le cornet.

Alternativement la matrice $T^{-1}$ peut également être déterminée par simulation à partir des données d'orientation de la table trois axes 13 sur laquelle le senseur 21 est placé et de la connaissance de la forme d'onde émise par le senseur.

De manière alternative également, la matrice $T^{-1}$ peut être mémorisée dans une base de données élaborée lors d'une opération d'étalonnage consistant à déterminer et à mémoriser, pour différentes orientations de la table trois axes 13 et pour différents groupes de cornets (dans le cas où, le panneau rayonnant comportant plus de N cornets, il est possible de choisir les N cornets utilisés par le dispositif), les coefficients de la matrice $T^{-1}$.

L'identification des coefficients de la matrice $T^{-1}$ par étalonnage peut alors consister à exciter les cornets d'émission RF 151 à 15N tour à tour. Les mesures des signaux reçus par le senseur au niveau de chaque module de réception 231 à 23N définissent alors les colonnes de la matrice de transfert T. Cette matrice est ensuite inversée pour obtenir la matrice $T^{-1}$.

Cette identification peut, alternativement, être réalisée, quand cela est techniquement possible, en excitant les modules de réception 231 à 23N un à un. Les mesures des signaux reçus au niveau de chaque cornet RF 151 à 15N définissent alors directement les colonnes de la matrice $T^{-1}$, de sorte qu'aucune inversion de matrice n'est à effectuer.

Une fois la matrice $T^{-1}$ déterminée l'opération de suppression de transfert se poursuit en construisant, pour chaque cellule Doppler - distance, un vecteur réception 34 dont les N composantes correspondent aux valeurs d'amplitude prises par le signal dans la cellule considérée pour chacune des N cartes Doppler - distance 2421 à 242N produites par le calculateur de scènes électromagnétiques 241, puis en multipliant le vecteur 34 ainsi formé par la matrice $T^{-1}$. Le

vecteur produit ainsi obtenu, ou vecteur émission 35, est un vecteur à N composantes.

L'obtention d'un vecteur émission pour chaque pixel (Doppler - distance) considéré permet alors de construire N cartes Doppler - distance 2441 à 244N corrigées, de dimensions identiques à celles des cartes Doppler-distance produites par le calculateur de scènes électromagnétiques 241, chaque carte corrigée de rang i comportant la composante de rang i de chacun des vecteurs émission 35.

Le produit scalaire de la matrice de transfert inverse $T^{-1}$, 33, avec le vecteur réception 34 est effectué dans le multiplieur 32. Le multiplieur 32 retourne un vecteur émission 35, chaque composante du vecteur émission 35 correspondant à l'amplitude d'un pixel d'une des cartes Doppler - distance 2441 à 244N.

Les cartes Doppler - distance 2441 à 244N sont ainsi estimées en balayant tous les pixels des cartes 2421 à 242N en appliquant le procédé décrit précédemment. Ces cartes corrigées 2441 à 244N ont les mêmes dimensions que les cartes Doppler-distance initiales 2421 à 242N produites par le calculateur de scènes électromagnétiques 241. Elles constituent une représentation fréquentielle du signal que doit émettre chaque cornet 151 à 15N.

Les générateurs de signaux 2451 à 245N ont pour fonction, comme l'illustre la figure 4, de convertir les cartes Doppler - distance 2441 à 244N en signaux temporels destinés à exciter les cornets rayonnants 151 à 15N.

La conversion de la représentation Doppler - distance en une représentation temporelle est opérée par chaque module de calcul 41i qui applique aux pixels formant une même ligne de la carte Doppler-distance (ligne iso-distance) une transformée de Fourier inverse TFI de façon qui conduit à obtenir une carte 42i représentant le signal dans un espace "temps long" - "temps court", le temps long représentant les périodes successives d'acquisition des signaux par le senseur 21 (périodes de récurrence) et le temps court représentant les échantillons distance prélevés par le senseur 21 au cours d'une même période d'acquisition (échantillons distance).

Une carte "temps long" - "temps court" 42i est ainsi formée de cellules, chaque cellule étant repérée sur la carte par un numéro de récurrence sur l'axe temps long et un numéro de case distance (un intervalle de distance) sur l'axe temps court et renfermant un échantillon de signal ou pixel p' dont l'amplitude correspond à l'amplitude du signal rétrodiffusé par la scène pour la distance et la récurrence considérée.

Les valeurs des amplitudes des pixels d'une colonne de la carte "N° de récurrence" - "N° d'échantillon distance" 42i représentent l'énergie des paquets d'ondes enregistrés par le senseur à différents instants au cours de la récurrence correspondante.

Chacune des cartes "temps long" - "temps court" 42i est exploitée par un module de calcul 43i qui reçoit les informations relatives aux données de fonctionnement du senseur, les caractéristiques de la forme d'onde émise notamment. À partir de ces données, le module de calcul 43i considéré, délivre au cornet 15i correspondant, récurrence après récurrence, un signal temporel qui correspond à la concaténation des pixels formant une même période d'acquisition (i.e. une même récurrence), les pixels étant délivrés au rythme de la période d'échantillonnage avec laquelle le senseur 21 échantillonne les signaux captés par les modules de réception 231 à 23N.

Les signaux temporels ainsi formés sont transmis aux cornets 151 à 15N puis émis dans la chambre anéchoïque 12 vers le senseur 21. La distribution spatiale du signal émis au niveau du plan de l'antenne 22 du senseur 21 résultant de la recombinaison des signaux émis par les cornets 151 à 15N est proche du signal rétrodiffusé par la scène électromagnétique estimée par le calculateur de scènes électromagnétiques 2411.

Tel qu'il est décrit structurellement et fonctionnellement dans les paragraphes précédents, le dispositif 24 de génération d'environnements électromagnétiques complexes selon l'invention met en œuvre un certain nombre d'opérations.

La première opération consiste pour le calculateur de scènes 241 à former, pour une scène électromagnétique simulée donnée (scénario d'environnement), des cartes Doppler - distance telles que celles qui pourraient être constituées à partir des signaux captés par les modules de réception 231 à 23N de l'antenne 22 du senseur 21, pour chacune de ses voies de réception, dans cet environnement.

Cette scène électromagnétique est produite en mettant en œuvre un logiciel de génération de scénarios de simulation d'environnement qui produit, pour chaque voie d'acquisition du senseur 21 et pour chaque séquence d'acquisition, des cartes Doppler-distance qui correspondent à l'environnement simulé.

La deuxième opération implémentée par le module de suppression de transfert 243 consiste à supprimer, au niveau de la carte Doppler - distance courante considérée, le transfert à travers la chambre anéchoïque. Connaissant la position du senseur 21 à tester relativement aux cornets 151 à 15N du panneau rayonnant 14 utilisés pour procéder au test, on peut en effet estimer le transfert en amplitude et en phase dû à l'espace séparant le senseur de ces derniers. La suppression de ce transfert permet de disposer d'une estimation des spectres des signaux que doivent émettre les cornets 151 à 15N pour que le senseur 21 perçoive un environnement électromagnétique correspondant sensiblement au scénario élaboré par simulation.

La troisième opération consiste, pour les générateurs de signaux 2451 à 245N, à convertir en signaux temporels les spectres des signaux destinés à exciter les cornets, puis à émettre ces signaux temporels vers le senseur 21, via les cornets, à travers la chambre anéchoïque 12.

Ces opérations peuvent être suivies, dans un mode de mise en œuvre particulier, d'une opération complémentaire consistant à faire l'acquisition des signaux captés par les modules d'antenne du senseur pendant le déroulement du scénario de test considéré, de former une carte Doppler - distance à partir des signaux enregistrés, lors du test, au niveau des modules d'antenne pour chacune des voies de réception. La carte obtenue peut avantageusement être comparée à celle élaboré par simulation.

Avantageusement le dispositif selon l'invention traite de façon identique tous les objets radioélectriques (ORE) dont il est possible de décrire la structure et le comportement au moyen de cartes Doppler - distance. L'invention fournit donc un moyen de n'avoir qu'un seul mode de génération pour tous les ORE existants (fouillis, pluie, cibles, brouilleurs...).

Si l'on considère une installation de test comportant un dispositif de génération d'environnements électromagnétiques complexes selon l'invention on constate que celle-ci peut être mise en œuvre de différentes façons.

Selon un mode de mise en œuvre nominal, l'installation utilise les commandes d'orientation de la table trois axes 13 pour pouvoir, le cas échéant, reproduire la dynamique d'un véhicule porteur. Dans ce cas d'utilisation, le module de suppression de transfert 243 utilise les données 19 provenant de la table trois axes 13 qui doivent lui être transmises par le module d'acquisition de données 247 à chaque nouvelle analyse afin de déterminer les coefficients de la matrice de transfert inverse 33.

Selon un mode de mise en œuvre allégé, la table trois axes 13 est maintenue en position fixe durant tout le scenario de test. Dans ce mode de mise en œuvre, les caractéristiques décrivant l'état de la table trois axes 13 sont transmises au module de suppression de transfert 243 au début du scenario de test. La matrice de transfert inverse 33 est estimée une seule fois et reste la même pour toute la durée du scénario.

Le dispositif selon l'invention permet avantageusement de reproduire, au voisinage du senseur, un signal équivalent à celui généré par une scène électromagnétique complexe. La scène électromagnétique générée peut comporter des objets naturels complexes comme par exemple une zone de terrain, une zone marine ou encore une zone atmosphérique pluvieuse accompagnés de cibles.

A ce titre, le module selon l'invention peut avantageusement être intégré à une installation de test 11 existante telle que celle illustrée par la figure 1 et venir se substituer aux moyens de génération d'échos de test existants, moyens généralement configurés pour générer des ORE simulant des échos de cibles ponctuelles fixes ou mobiles.

Alternativement, cependant, le dispositif selon l'invention peut également venir compléter ces moyens et prendre en charge la simulation des objets complexes générateurs de fouillis tandis que les moyens de génération d'échos de test existants restent utilisés pour la simulation d'échos ponctuels fixes ou mobile. Dans ce cas, dans la mesure où le dispositif selon l'invention ne requiert pour sa mise en œuvre qu'un nombre N de cornets rayonnants égal au nombre de voie de réception du senseur sous test, il est avantageusement possible d'utiliser les autres cornets formant le panneau rayonnant pour émettre des signaux radioélectriques correspondant à des échos de cibles ponctuelles.

**Revendications**

1. Dispositif de génération d'environnements électromagnétiques complexes (24) destiné à produire des signaux électromagnétiques de test pour stimuler un senseur électromagnétique (21-22) comportant N voies de réception, placé sur un support (13) dans une enceinte de test (11) comportant une chambre anéchoïque (12) et un panneau rayonnant (14) constitué d'au moins N sources rayonnantes (151-15N) et configuré pour être raccordé à un équipement de génération de signaux RF d'excitation, et rayonner l'onde électromagnétique correspondante à l'intérieur de la chambre anéchoïque vers le matériel sous test, comportant principalement:

   - un module de définition de scènes électromagnétiques (246) qui délivre des données qui définissent l'environnement électromagnétique que l'on veut simuler et auquel on veut soumettre le senseur sous test;
   - un calculateur de scènes électromagnétiques (241) qui produit des ensembles de cartes Doppler - distance (2421-242N), chaque carte représentant, pour une séquence d'acquisition donnée et pour une voie de réception (231-23N) donnée du senseur, la distribution en fréquence, en fonction de la distance, de la puissance du signal reçu pour l'environnement électromagnétique défini par le module de définition de scènes électromagnétiques (246);
   - un module de suppression de transfert (243) qui modifie chaque carte Doppler - distance (2421-242N) produite par le calculateur de scènes électromagnétiques (241) de façon à produire une cartes Doppler - distance modifiée (2441 à 244N), correspondant au signal que doit rayonner une sources rayonnante (151-15N) donnée du panneau rayonnant (14) pour simuler, au niveau des voies de réception (231-23N) du senseur (21), l'environnement électromagnétique souhaité pour la séquence d'acquisition correspondante;
   - des modules (2451-245N) de synthèse et d'amplification de signaux radiofréquence (RF), chaque module réalisant la synthèse du signal RF correspondant à une carte Doppler - distance modifiée donnée (2441 à 244N) produite par le module de suppression de transfert (243), le signal RF produit étant délivré à une source rayonnante (151-15N) donnée ;

**caractérisé en ce que**
ledit module de suppression de transfert (243) comportant :

- un processeur (31) configuré pour construire la matrice inverse $T^{-1}$ (33) de la matrice de transfert $T$ qui caractérise la propagation des ondes électromagnétiques émises par les sources rayonnantes (151-15N) du panneau rayonnant (14) jusqu'aux modules de réception (231-23N) du senseur (21) pour une fréquence Doppler donnée;
- un multiplieur (32) configuré pour effectuer le produit de la matrice inverse $T^{-1}$ (33) par un vecteur réception (34) dont les N composantes correspondent, pour une séquence d'acquisition donnée du senseur, aux valeurs de l'amplitude de signal mesurée dans une même cellule doppler-distance de chacune des N cartes Doppler - distance (2421 à 242N) produites par le calculateur de scènes électromagnétiques (241) pour la séquence d'acquisition considérée; le vecteur émission (35) ainsi obtenu étant un vecteur à N composantes, chaque composante représentant la valeur de l'amplitude du signal à émettre par la source rayonnante considéré mesuré pour une même cellule doppler-distance de chacune des cartes doppler-distance modifiées (2441-244N) délivrées par le module de suppression de transfert (243).

2. Dispositif selon la revendication 1, **caractérisé en ce que** le support (13) de l'enceinte de test (11) étant une table trois axes, le dispositif comporte un module (247) d'acquisition des données provenant de ladite table trois axes (13), ces données étant transmises au module de suppression de transfert (243);

3. Dispositif selon l'une des revendications 1 ou 2, **caractérisé en ce qu'**il comporte un module (248) d'acquisition de données de fonctionnement du senseur (21-22), ces données étant transmises au module de suppression de transfert (243) et au calculateur de scènes électromagnétiques (241).

4. Dispositif selon l'une des revendications 1 à 3, **caractérisé en ce qu'**il comporte en outre des moyens de commutation permettant de connecter chaque module (2451-245N) de synthèse et d'amplification de signaux à l'une ou l'autre des sources rayonnantes (151-15N) du panneau rayonnant (14).

5. Dispositif selon l'une quelconque des revendications précédentes, **caractérisé en ce que** le processeur (31) est configuré pour calculer une matrice inverse $T^{-1}$ distincte pour chacune des fréquences doppler définissant les cellules doppler-distance des cartes doppler-distance (2421-242N) produites par le calculateur de scènes électromagnétiques (241).

6. Dispositif selon l'une quelconque des revendications précédentes, **caractérisé en ce que** le processeur (31) est configuré pour calculer une matrice inverse $T^{-1}$ commune unique, ladite matrice étant calculée pour la fréquence doppler définissant la cellule doppler-distance centrale des cartes doppler-distance (2421-242N) produites par le calculateur de scènes électromagnétiques (241).

7. Dispositif selon l'une quelconque des revendications précédentes, **caractérisé en ce que** chaque module (2451-245N) de synthèse et d'amplification de signaux radiofréquence (RF) comporte:

- un processeur (41i) configuré pour mettre en œuvre une opération de transformation de Fourier inverse permettant de transformer la carte doppler-distance modifiée (2441-244N) à laquelle il est associé en une carte temps court-temps long (42) constitué de cellules, l'amplitude du signal dans chaque cellule correspondant à l'amplitude du signal à rayonner pour une case distance donnée et une récurrence donnée du signal d'excitation;
- un module synthétiseur configuré pour générer un signal électromagnétique temporel fonction, pour chaque récurrence, des amplitudes de signal dans chacune des cellules temps court-temps long de la carte temps court-temps long (42) définies par un même numéro de récurrence sur l'axe temps long.

8. Procédé de génération d'environnements électromagnétiques complexes destiné à produire des signaux électromagnétiques de test pour stimuler un senseur électromagnétique sous test (21-22) placé sur un support (13) dans une enceinte de test (11) comportant une chambre anéchoïque (12) et un panneau rayonnant (14) constitué d'une pluralité de sources rayonnantes (151-15N) et configuré pour être raccordé à un équipement de génération de signaux RF d'excitation, et rayonner l'onde électromagnétique correspondante à l'intérieur de la chambre anéchoïque vers le senseur à tester, ledit procédé mettant en œuvre un dispositif (24) de génération d'environnements électromagnétiques complexes selon l'une quelconque des revendications 1 à 7 **caractérisé en ce qu'**il comporte:

- une première opération consistant à former, pour un scénario d'environnement électromagnétique donné, des cartes Doppler - distance telles que celles qui pourraient être constituées par le senseur à tester (21), pour chacune de ses voies de réception, dans un tel environnement, à partir des signaux captés par les modules de réception (231 à 23N) dudit senseur ;

- une deuxième opération consistant à supprimer, au niveau de chaque carte Doppler - distance formée, le transfert à travers la chambre anéchoïque, en prenant en compte la position du senseur (21) à tester relativement aux sources rayonnantes (151 à 15N) du panneau rayonnant (14) utilisées, de façon à former des cartes Doppler - distance modifiées (2441-244N) représentant les spectres des signaux que doivent émettre les sources rayonnantes (151 à 15N) pour que le senseur (21) perçoive un environnement électromagnétique correspondant sensiblement au scénario élaboré ;

- une troisième opération consistant, pour les générateurs de signaux (245a à 245N), à convertir en signaux temporels les spectres des signaux correspondant aux cartes Doppler - distance modifiées (2441-244N), puis à rayonner ces signaux vers le senseur (21), via les sources rayonnantes (151 à 15N), à travers la chambre anéchoïque (12).

9. Procédé de génération d'environnements électromagnétiques complexes selon la revendication 8, **caractérisé en ce qu'**il comporte en outre une opération complémentaire consistant à faire l'acquisition des signaux captés par les modules de réception (231 à 23N) du senseur pendant le déroulement du scénario de test considéré et de former des carte Doppler - distance (2421-242N) à partir des signaux enregistrés, lors du test, au niveau des modules de réception (231 à 23N) du senseur pour chacune des voies de réception.

**Patentansprüche**

1. Vorrichtung zur Erzeugung komplexer elektromagnetischer Umgebungen (24), bestimmt zum Produzieren von elektromagnetischen Testsignalen zur Stimulierung eines elektromagnetischen Sensors (21-22) mit N Empfangskanälen, platziert auf einem Träger (13) in einer Testbox (11), die eine anechoische Kammer (12) und eine Strahlungsplatte (14) umfasst, die aus mindestens N Strahlungsquellen (151-15N) besteht und zum Anschließen an ein RF-Anregungssignalerzeugungsgerät und zum Abstrahlen der entsprechenden elektromagnetischen Welle im Inneren der anechoischen Kammer in Richtung des zu testenden Materials konfiguriert ist, die im Wesentlichen Folgendes umfasst:

- ein Modul zum Definieren elektromagnetischer Szenen (246), das Daten liefert, die die elektromagnetische Umgebung definieren, die simuliert werden soll und der der zu testende Sensor ausgesetzt werden soll ;
- einen Rechner für elektromagnetische Szenen (241), der Sätze von Entfernungs-Doppler-Karten (2421-242N) produziert, wobei jede Karte, für eine gegebene Erfassungssequenz und für einen gegebenen Empfangskanal (231-23N) des Sensors, die Frequenzverteilung, in Abhängigkeit von der Entfernung, der Leistung des empfangenen Signals für die durch das Modul zur Definition der elektromagnetischen Szenen (246) definierte elektromagnetische Umgebung darstellt ;
- ein Übertragungsunterdrückungsmodul (243), das jede von dem Rechner für elektromagnetische Szenen (241) produzierte Entfernungs-Doppler-Karte (2421-242N) modifiziert, um eine modifizierte Entfernungs-Doppler-Karte (2441-244N) zu produzieren, entsprechend dem Signal, das von einer gegebenen Strahlungsquelle (151-15N) der Strahlungsplatte (14) abgestrahlt werden muss, um an den Empfangskanälen (231-23N) des Sensors (21) die gewünschte elektromagnetische Umgebung für die entsprechende Erfassungssequenz zu simulieren ;
- Module (2451-245N) zum Synthetisieren und Verstärken von Radiofrequenzsignalen (RF), wobei jedes Modul die Synthese des RF-Signals entsprechend einer gegebenen modifizierten Entfernungs-Doppler-Karte (2441-244N) durchführt, die von dem Übertragungsunterdrückungsmodul (243) produziert wird, wobei das produzierte RF-Signal zu einer gegebenen Strahlungsquelle (151-15N) gesendet wird ;

**dadurch gekennzeichnet, dass**
das Übertragungsunterdrückungsmodul (243) Folgendes umfasst:

- einen Prozessor (31), konfiguriert zum Konstruieren der inversen Matrix T $^{1}$ (33) der Übertragungsmatrix T, die die Ausbreitung der von den Strahlungsquellen (151-15N) der Strahlungsplatte (14) zu den Empfangsmodulen (231-23N) des Sensors (21) für eine gegebene Dopplerfrequenz emittierten elektromagnetischen Wellen charakterisiert ;
- einen Multiplizierer (32), konfiguriert zum Bilden des Produkts der inversen Matrix $T^1$ (33) durch einen Emp-

fangsvektor (34), dessen N Komponenten für eine gegebene Erfassungssequenz des Sensors den Werten der in einer selben Entfernungs-Doppler-Zelle jeder der N Entfernungs-Doppler-Karten (2421-242N) gemessenen Signalamplitude entsprechen, die von dem Rechner für elektromagnetische Szenen (241) für die betrachtete Erfassungssequenz produziert werden; wobei der so erhaltene Emissionsvektor (35) ein Vektor mit N Komponenten ist, wobei jede Komponente den Wert der Amplitude des von der betrachteten Strahlungsquelle zu emittierenden Signals repräsentiert, gemessen für eine selbe Entfernungs-Doppler-Zelle jeder der vom Übertragungsunterdrückungsmodul (243) gesendeten modifizierten Entfernungs-Doppler- Karten (2441-244N).

2.  Vorrichtung nach Anspruch 1, **dadurch gekennzeichnet, dass** der Träger (13) der Testbox (11) ein Drei-Achsen-Tisch ist und die Vorrichtung ein Modul (247) zum Erfassen der von dem Drei-Achsen-Tisch (13) kommenden Daten umfasst, wobei diese Daten zum Übertragungsunterdrückungsmodul (243) übertragen werden.

3.  Vorrichtung nach Anspruch 1 oder 2, **dadurch gekennzeichnet, dass** sie ein Modul (248) zur Erfassung von Betriebsdaten des Sensors (21-22) umfasst, wobei diese Daten zum Übertragungsunterdrückungsmodul (243) und zum Rechner für elektromagnetische Szenen (241) übertragen werden.

4.  Vorrichtung nach einem der Ansprüche 1 bis 3, **dadurch gekennzeichnet, dass** sie außerdem Schaltmittel umfasst, die es zulassen, jedes Modul (2451-245N) zum Synthetisieren und Verstärken von Signalen mit der einen oder der anderen der Strahlungsquellen (151-15N) der Strahlungsplatte (14) zu verbinden.

5.  Vorrichtung nach einem der vorhergehenden Ansprüche, **dadurch gekennzeichnet, dass** der Prozessor (31) zum Berechnen einer separaten inversen Matrix $T^{-1}$ für jede der Dopplerfrequenzen konfiguriert ist, die die Entfernungs-Doppler-Zellen der Entfernungs-Doppler-Karten (2421-242N) definieren, die von dem Rechner für elektromagnetische Szenen (241) produziert werden.

6.  Vorrichtung nach einem der vorhergehenden Ansprüche, **dadurch gekennzeichnet, dass** der Prozessor (31) zum Berechnen einer einzigen gemeinsamen inversen Matrix $T^{-1}$ konfiguriert ist, wobei die Matrix für die Dopplerfrequenz berechnet wird, die die zentrale Entfernungs-Doppler-Zelle der von dem Rechner für elektromagnetische Szenen (241) produzierten Entfernungs-Doppler-Karten (2421-242N) definiert.

7.  Vorrichtung nach einem der vorhergehenden Ansprüche, **dadurch gekennzeichnet, dass** jedes Modul (2451-245N) zum Synthetisieren und Verstärken von Radiofrequenzsignalen (RF) Folgendes umfasst:

    - einen Prozessor (41i), konfiguriert zum Durchführen einer inversen Fourier-Transformation, mit der die modifizierte Entfernungs-Doppler-Karte (2441-244N), mit der er assoziiert ist, in eine aus Zellen bestehende Kurzzeit-Langzeit-Karte (42) umgewandelt werden kann, wobei die Amplitude des Signals in jeder Zelle der Amplitude des abzustrahlenden Signals für einen gegebenen Entfernungsfall und eine gegebene Wiederkehr des Anregungssignals entspricht;
    - ein Synthetisiermodul, konfiguriert zum Erzeugen eines elektromagnetischen Zeitsignals in Abhängigkeit, für jede Wiederkehr, von den Signalamplituden in jeder der Kurzzeit-Langzeit-Zellen der Kurzzeit-Langzeit-Karte (42), die durch eine selbe Wiederkehrnummer auf der Langzeitachse definiert sind.

8.  Verfahren zum Erzeugen komplexer elektromagnetischer Umgebungen, bestimmt zum Produzieren von elektromagnetischen Testsignalen zur Stimulierung eines zu testenden elektromagnetischen Sensors (21-22), platziert auf einem Träger (13) in einer Testbox (11), die eine anechoische Kammer (12) und eine Strahlungsplatte (14) umfasst, die aus mehreren Strahlungsquellen (151-15N) gebildet und zum Anschließen an ein RF-Anregungssignalerzeugungsgerät und zum Abstrahlen der entsprechenden elektromagnetischen Welle innerhalb der anechoischen Kammer in Richtung des zu testenden Sensors konfiguriert ist, wobei das Verfahren eine Vorrichtung (24) zur Erzeugung komplexer elektromagnetischer Umgebungen nach einem der Ansprüche 1 bis 7 einsetzt, **dadurch gekennzeichnet, dass** es Folgendes umfasst:

    - eine erste Operation, die darin besteht, für ein gegebenes elektromagnetisches Umgebungsszenario Entfernungs-Doppler-Karten zu bilden, wie sie von dem zu testenden Sensor (21) für jeden seiner Empfangskanäle in einer solchen Umgebung auf der Basis der von den Empfangsmodulen (231 bis 23N) des Sensors erfassten Signale gebildet werden könnten;
    - eine zweite Operation, die darin besteht, an jeder gebildeten Entfernungs-Doppler-Karte die Übertragung durch die anechoische Kammer, unter Berücksichtigung der Position des zu testenden Sensors (21) relativ zu den verwendeten Strahlungsquellen (151 bis 15N) der Strahlungsplatte (14), zu unterdrücken, um modifizierte Entfernungs-Doppler-Karten (2441-244N) zu bilden, die die Spektren der Signale darstellen, die die Strahlungsquellen (151 bis 15N) emittieren müssen, damit der Sensor (21) eine elektromagnetische Umgebung wahrnimmt, die im Wesentlichen dem ausgearbeiteten Szenario entspricht;

- eine dritte Operation, die darin besteht, für die Signalgeneratoren (245a bis 245N) die Signalspektren entsprechend den modifizierten Entfernungs-Doppler-Karten (2441 bis 244N) in Zeitsignale umzuwandeln und diese Signale dann über die Strahlungsquellen (151 bis 15N) durch die anechoische Kammer (12) zum Sensor (21) abzustrahlen.

9. Verfahren zum Erzeugen komplexer elektromagnetischer Umgebungen nach Anspruch 8, **dadurch gekennzeichnet, dass** es außerdem eine komplementäre Operation umfasst, die darin besteht, die von den Empfangsmodulen (231-23N) des Sensors während des Ablaufs des betrachteten Testszenarios erfassten Signale aufzunehmen und Entfernungs-Doppler-Karten (2421-242N) auf der Basis der während des Tests an den Empfangsmodulen (231-23N) des Sensors für jeden der Empfangskanäle registrierten Signale zu bilden.

## Claims

1. A device for generating complex electromagnetic environments (24) intended to produce test electromagnetic signals for stimulating an electromagnetic sensor (21-22) comprising N reception channels, placed on a support (13) in a test enclosure (11) comprising an anechoic chamber (12) and a radiating panel (14) formed by at least N radiating sources (151-15N) and configured to be connected to an item of equipment for generating RF excitation signals, and radiating the corresponding electromagnetic wave inside the anechoic chamber towards the hardware under test, mainly comprising:

   - a module (246) for defining electromagnetic scenes that delivers data that defines the electromagnetic environment to be simulated and to which the sensor under test is to be subjected;
   - an electromagnetic scenes computer (241) that produces sets of Doppler-distance maps (2421-242N), with each map representing, for a given acquisition sequence and for a given reception channel (231-23N) of the sensor, the frequency distribution, as a function of the distance, of the power of the received signal for the electromagnetic environment defined by the module (246) for defining electromagnetic scenes;
   - a transfer suppression module (243) that modifies each Doppler-distance map (2421-242N) produced by the electromagnetic scenes computer (241) so as to produce a modified Doppler-distance map (2441 to 244N), corresponding to the signal that a given radiating source (151-15N) of the radiating panel (14) must radiate in order to simulate, at the reception channels (231-23N) of the sensor (21), the desired electromagnetic environment for the corresponding acquisition sequence;
   - modules (2451-245N) for synthesising and amplifying radiofrequency (RF) signals, with each module synthesising the RF signal corresponding to a given modified Doppler-distance map (2441 to 244N) produced by the transfer suppression module (243), the produced RF signal being delivered to a given radiating source (151-15N);

   **characterised in that** said transfer suppression module (243) comprises:

   - a processor (31) configured to construct the inverse matrix $T^{-1}$ (33) of the transfer matrix T that characterises the propagation of the electromagnetic waves emitted by the radiating sources (151-15N) of the radiating panel (14) to the reception modules (231-23N) of the sensor (21) for a given Doppler frequency;
   - a multiplier (32) configured to determine the product of the inverse matrix $T^{-1}$ (33) using a reception vector (34), the N components of which correspond, for a given acquisition sequence of the sensor, to the values of the signal amplitude measured in the same Doppler-distance cell of each of the N Doppler-distance maps (2421 to 242N) produced by the electromagnetic scenes computer (241) for the considered acquisition sequence; the emission vector (35) thus obtained being a vector with N components, with each component representing the value of the amplitude of the signal to be emitted by the radiating source that is considered to be measured for the same Doppler-distance cell of each of the modified Doppler-distance maps (2141-244N) delivered by the transfer suppression module (243).

2. The device as claimed in claim 1, **characterised in that**, with the support (13) of the test enclosure (11) being a three-axis table, the device comprises a module (247) for acquiring data originating from said three-axis table (13), said data being transmitted to the transfer suppression module (243).

3. The device as claimed in any of claims 1 or 2, **characterised in that** it comprises a module (248) for acquiring operating data of the sensor (21-22), said data being transmitted to the transfer suppression module (243) and to the electromagnetic scenes computer (241).

4. The device as claimed in any of claims 1 to 3, **characterised in that** it further comprises communication means allowing each module (2451-245N) for synthesising and amplifying signals to be connected to either one of the radiating sources (151-15N) of the radiating panel (14).

5. The device as claimed in any one of the preceding claims, **characterised in that** the processor (31) is configured to compute a separate inverse matrix $T^{-1}$ for each of the Doppler frequencies defining the Doppler-distance cells of the Doppler-distance maps (2421-242N) produced by the electromagnetic scenes computer (241).

6. The device as claimed in any one of the preceding claims, **characterised in that** the processor (31) is configured to compute a single, common inverse matrix $T^{-1}$, said matrix being computed for the Doppler frequency defining the central Doppler-distance cell of the Doppler-distance maps (2421-242N) produced by the electromagnetic scenes computer (241).

7. The device as claimed in any one of the preceding claims, **characterised in that** each module (2451-245N) for synthesising and amplifying radiofrequency (RF) signals comprises:

   - a processor (41i) configured to implement an inverse Fourier transform operation allowing the modified Doppler-distance map (2441-244N) with which it is associated to be transformed into a short time-long time map (42) made up of cells, with the amplitude of the signal in each cell corresponding to the amplitude of the signal to be radiated for a given distance box and a given recurrence of the excitation signal;
   - a synthesiser module configured to generate a temporal electromagnetic signal as a function of, for each recurrence, signal amplitudes in each of the short time-long time cells of the short time-long time map (42) defined by the same recurrence number on the long time axis.

8. A method for generating complex electromagnetic environments intended to produce test electromagnetic signals for stimulating an electromagnetic sensor (21-22) under test placed on a support (13) in a test enclosure (11) comprising an anechoic chamber (12) and a radiating panel (14) formed by a plurality of radiating sources (151-15N) and configured to be connected to an item of equipment for generating RF excitation signals, and radiating the corresponding electromagnetic wave inside the anechoic chamber towards the sensor under test, said method implementing a device (24) for generating complex electromagnetic environments as claimed in any one of claims 1 to 7, **characterised in that** it comprises:

   - a first operation involving forming, for a given electromagnetic environment scenario, Doppler-distance maps such as those that can be formed by the sensor (21) under test, for each of the reception channels thereof, in such an environment, on the basis of the signals detected by the reception modules (231 to 23N) of said sensor;
   - a second operation involving suppressing, on each formed Doppler-distance map, the transfer through the anechoic chamber, by taking into account the position of the sensor (21) under test relative to the radiating sources (151 to 15N) of the radiating panel (14) used, so as to form modified Doppler-distance maps (2441-244N) representing the spectra of the signals that must emit the radiating sources (151 to 15N) so that the sensor (21) perceives an electromagnetic environment substantially corresponding to the developed scenario;
   - a third operation involving, for the signal generators (245a to 245N), converting the spectra of the signals corresponding to the modified Doppler-distance maps (2441-244N) into temporal signals, then radiating these signals towards the sensor (21), via the radiating sources (151 to 15N), through the anechoic chamber (12).

9. The method for generating complex electromagnetic environments as claimed in claim 8, **characterised in that** it further comprises an additional operation involving acquiring signals detected by the reception modules (231 to 23N) of the sensor during the course of the considered test scenario and involving forming Doppler-distance maps (2421-242N) on the basis of the signals recorded during the test at the reception modules (231 to 23N) of the sensor for each of the reception channels.

Fig. 1

EP 3 575 821 B1

Fig. 2

Fig. 3

EP 3 575 821 B1

Fig. 4

Fig. 5

**EP 3 575 821 B1**

## RÉFÉRENCES CITÉES DANS LA DESCRIPTION

**Documents brevets cités dans la description**

- US 6114985 A